# EUROPEAN PATENT APPLICATION

(11) **EP 2 824 154 A1**
(43) Date of publication of application: **14.01.2015**
(21) Application number: 13758154.2
(22) Date of filing: 08.03.2013
(51) Int. Cl.: C09J 123/08, C09J 193/04

(54) **HOT-MELT ADHESIVE COMPOSITION**

(30) Priority: 08.03.2012 JP 2012051371
(71) Applicant: Arakawa Chemical Industries, Ltd., Osaka-shi Osaka 541-0046 (JP)
(72) Inventor: NAKATANI, Takashi, Osaka-shi Osaka 538-0053 (JP)
(74) Representative: Haslam, Simon David
(86) International application number: PCT/JP2013/056435
(87) International publication number: WO 2013/133407

(57) **Abstract**

The present invention provides a hot melt adhesive composition comprising (A) an ethylene copolymer obtained by copolymerizing ethylene and α-olefin using a single-site catalyst and (B) a rosin ester, in a hydrolyzate of which a dehydroabietic acid content is 30 wt% or less and an abietic acid content is 10 wt% or less, and in a methylated product of the hydrolyzate of which a content of components having a molecular weight of 320 is equal to or greater than 10 wt% of a total amount of components having a molecular weight of 314 to 320.

## Description

### TECHNICAL FIELD

The present invention relates to an ethylene copolymer-based hot melt adhesive composition.

### BACKGROUND ART

Ethylene copolymers obtained by copolymerizing ethylene and α-olefin in the presence of a single-site catalyst have a sharp molecular weight distribution, are characterized in, for example, few low-boiling fractions, have excellent hot tack properties and strength, and are therefore used for hot melt adhesives (see Patent Literature 1).

However, ethylene copolymers are problematic in that since their polarity is low, adhesion to highly polar adherends is in some cases not sufficient, and it is difficult to demonstrate satisfactory adhesion to, in particular, highly smooth film substrates, paper substrates, and the like.

Addition of a tackifier resin is proposed to improve adhesion (see Patent Literature 1).

However, mere addition of a conventionally known tackifier resin does not necessarily result in improved adhesion.

### CITATION LIST

### PATENT LITERATURE

Patent Literature 1: JP H10-147672A

### SUMMARY OF INVENTION

### TECHNICAL PROBLEM

An object of the present invention is to provide an ethylene copolymer-based hot melt adhesive composition having excellent adhesion to adherends having a broad range of polarity.

### SOLUTION TO PROBLEM

The inventors conducted diligent research to solve the above problem. As a result, the inventors found that the above object can be achieved by blending a specific ethylene copolymer (A) with a specific rosin ester (B) as a tackifier, and the inventors conducted further research based on this finding and accomplished the present invention.

The present invention provides a hot melt adhesive composition as presented below.
1. A hot melt adhesive composition comprising:
   (A) an ethylene copolymer obtained by copolymerizing ethylene and α-olefin using a single-site catalyst, and
   (B) a rosin ester, in a hydrolyzate of which a dehydroabietic acid content is 30 wt% or less and an abietic acid content is 10 wt% or less, and in a methylated product of the hydrolyzate of which a content of components having a molecular weight of 320 is equal to or greater than 10 wt% of a total amount of components having a molecular weight of 314 to 320.
2. The hot melt adhesive composition according to Item 1, wherein the ethylene copolymer (A) has a melt flow rate of 2500 g/10 min (190°C, 21.2 N).
3. The hot melt adhesive composition according to Item 1 or 2, wherein the ethylene copolymer (A) has a density in a range of 0.86 to 0.92 g/cm³.
4. The hot melt adhesive composition according to any one of Items 1 to 3, wherein the rosin ester (B) is a rosin ester, in a hydrolyzate of which a dehydroabietic acid content is 20 wt% or less and an abietic acid content is 10 wt% or less, and in a methylated product of the hydrolyzate of which a content of components having a molecular weight of 320 is equal to or greater than 15 wt% of a total amount of components having a molecular weight of 314 to 320 in the methylated product.
5. The hot melt adhesive composition according to any one of Items 1 to 4, wherein the rosin ester (B) has a color tone of 3 or less on Gardner color scale specified in JIS K 0071-2.
6. The hot melt adhesive composition according to any one of Items 1 to 5, wherein the rosin ester (B) has a hydroxyl value of 30 mg KOH/g or less.
7. The hot melt adhesive composition according to any one of Items 1 to 6, wherein the rosin ester (B) is obtained by esterifying a rosin (b1) with an alcohol (b2) or a glycidyl group-containing compound (b3) and then hydrogenating an ester.
8. The hot melt adhesive composition according to Item 7, wherein the alcohol (b2) is a trihydric alcohol or an alcohol having a valency of 4 or greater.
9. The hot melt adhesive composition according to any one of Items 1 to 6, wherein the rosin ester (B) is obtained by hydrogenating a rosin (b1) and then esterifying a hydrogenate with an alcohol (b2) or a glycidyl group-containing compound (b3).
10. The hot melt adhesive composition according to Item 9, wherein the alcohol (b2) is a trihydric alcohol or an alcohol having a valency of 4 or greater.
11. The hot melt adhesive composition according to any one of Items 1 to 6, wherein the rosin ester (B) is obtained by hydrogenating a rosin (b1), further mixing the rosin (b1), and then esterifying a mixture with an alcohol (b2) or a glycidyl group-containing compound (b3).
12. The hot melt adhesive composition according to Item 11, wherein the alcohol (b2) is a trihydric alcohol or an alcohol having a valency of 4 or greater.
13. The hot melt adhesive composition according to any one of Items 1 to 12, having a content of the rosin ester (B) of 20 to 200 parts by weight based on 100 parts by weight of the ethylene copolymer (A).

### ADVANTAGEOUS EFFECTS OF INVENTION

Containing (A) an ethylene copolymer obtained by copolymerizing ethylene and α-olefin using a single-site catalyst and (B) a rosin ester having a specific component formulation as essential ingredients, the hot melt adhesive composition of the present invention provides remarkable effects as follows.
(1) Since the aforementioned ethylene copolymer (A) and the aforementioned rosin ester (B) show good compatibility, and the rosin ester (B) has excellent tackifying properties, the adhesive composition of the present invention demonstrates excellent adhesion.
(2) Since the rosin ester (B) in particular has suitable polarity, the adhesive composition of the present invention demonstrates excellent adhesion to a broad range of adherends from weakly polar adherends to highly polar adherends.
(3) Moreover, the adhesive composition of the present invention, due to its excellent adhesion, demonstrates satisfactory adhesion also to, for example, highly smooth substrates such as film substrates and paper substrates.

### DESCRIPTION OF EMBODIMENTS

### Hot melt adhesive composition

The hot melt adhesive composition of the present invention is characterized by containing (A) an ethylene copolymer obtained by copolymerizing ethylene and α-olefin using a single-site catalyst and (B) a rosin ester having a specific component formulation as essential ingredients.

### Ethylene copolymer (A)

The ethylene copolymer (A) used in the present invention is obtained by copolymerizing ethylene and α-olefin using a single-site catalyst. The single-site catalyst is a polymerization catalyst having a single active site, and performing polymerization using it as a catalyst makes it possible to obtain a polymer having a narrow molecular weight distribution and nearly identical comonomer contents.

With such an ethylene copolymer, a hot melt adhesive having excellent hot tack properties and durability can be obtained. Examples of single-site catalysts include metallocene catalysts such as a catalyst that is a transition metal complex composed of two cyclopentadienyl rings and zirconium and a catalyst composed of this complex and an organoaluminum compound, and similar catalysts.

The α-olefin for copolymerization with ethylene is not particularly limited, and known materials are usable. Specific examples are those having about 3 to about 20 carbon atoms, such as propylene, isobutylene, 1-butene, 1-pentene, 1-hexene, 1-octene, 1-decene, 1-dodecene, 4-methyl-1-butene, 3-methyl-1-pentene, 4-methyl-1-pentene, and the like.

It is preferable that the ethylene copolymer (A) has a melt flow rate of 2500 g/10 min or less at a temperature of 190°C and a load of 21.2 N for having excellent adhesion, heat seal properties, and the like. Moreover, it is preferable that the ethylene copolymer (A) has a density in a range of about 0.86 to about 0.92 g/cm³ for having excellent cohesion, flowability, and the like.

### Rosin ester (B)

The rosin ester (B) is used as a tackifier in the composition of the present invention. It is essential for the rosin ester (B) that in the hydrolyzate of which the dehydroabietic acid content is 20 wt% or less and in the hydrolyzate of which the abietic acid content is 10 wt% or less, and in the methylated product of the hydrolyzate of which the content of components having a molecular weight of 320 is equal to or greater than 15 wt% of the total amount of components having a molecular weight of 314 to 320 in the methylated product, and thereby the desired effects of the present invention are demonstrated. As long as these essential requirements are satisfied, any mixture of rosin esters such as fully hydrogenated rosin esters, partially hydrogenated rosin esters, and unhydrogenated rosin esters can be used as the rosin ester (B). Although it is also possible to use a fully hydrogenated rosin ester alone, it is usually preferable to use any such mixture in terms of, for example, enabling the rosin ester to have a pale color tone, cost reduction, and raw material availability.

It is necessary for the rosin ester (B) that in the hydrolyzate of which the content of dehydroabietic acid, which is a resin acid having an aromatic ring with three double bonds in the skeleton, of 30 wt% or less and the content of abietic acid, which is a resin acid having a conjugated double bond in the skeleton, of 10 wt% or less, among the resin acids in a rosin. A dehydroabietic acid content exceeding 30 wt% or an abietic acid content exceeding 10 wt% results in impaired compatibility with the component (A), and, therefore, adhesion does not improve. This is because an aromatic ring is present in dehydroabietic acid and a conjugated double bond is present in abietic acid, and, therefore, an increase of these components broadens the polarity difference between the component (A) and the component (B), resulting in impaired compatibility.

Moreover, it is necessary for the rosin ester (B) that in the methylated product of the hydrolyzate of which the content of components having a molecular weight of 320 is equal to or greater than 10 wt% of the total amount of components having a molecular weight of 314 to 320 in the methylated product. When the content of components having a molecular weight of 320 in the methylated product of the hydrolyzate of which is less than 10 wt% of the total amount of components having a molecular weight of 314 to 320 in the methylated product, adhesion does not improve. The components having a molecular weight of 320 in the methylated product of the hydrolyzate correspond to, among the resin acids in a rosin, resin acids in which all double bonds in the skeleton are hydrogenated and thus there is no double bond in the skeleton. Such resin acids have low polarity, and, therefore, having at least a certain content thereof improves compatibility with the component (A), and good adhesion is demonstrated. The total amount of components having a molecular weight of 314 to 320 corresponds to the total amount of resin acid components. Accordingly, the content of components having a molecular weight of 320 in the methylated product of the hydrolyzate being equal to or greater than 10 wt% of the total amount of components having a molecular weight of 314 to 320 in the methylated product indicates that the content of resin acid components without an unsaturated bond contained in resin acids is 10 wt% or greater, and means that resin acids having good compatibility with the component (A) are contained in a large amount, and thereby the compatibility of the component (B) with the component (A) becomes favorable, and adhesion is improved. The upper limit of the content of components having a molecular weight of 320 is not particularly limited.

In terms of attaining even better compatibility with the component (A), it is preferable for the rosin ester (B) that in the hydrolyzate of which the dehydroabietic acid content is 20 wt% or less and the abietic acid content is 10 wt% or less, and in the methylated product of the hydrolyzate of which the content of components having a molecular weight of 320 is equal to or greater than 15 wt% of the total amount of components having a molecular weight of 314 to 320 in the methylated product.

Rosin is a mixture of a large number of resin acids, and constituent resin acids have different polarities depending on the amount of double bond. A rosin ester obtained from rosin containing a large amount of highly polar resin acids has poor compatibility with the component (A) and does not exhibit good adhesion, and the effects of the present invention are not demonstrated. Therefore, it is necessary for the rosin ester (B) used in the present invention that in the hydrolyzate of which the contents of highly polar dehydroabietic acid and abietic acid are equal to or less than the contents specified herein, and in the methylated product of the hydrolyzate the content of low-polarity components having a molecular weight of 320 is equal to or greater than the content specified herein.

The contents of dehydroabietic acid and abietic acid in the hydrolyzate of the rosin ester (B) can be determined by hydrolyzing the component (B), then quantifying the acids by a gas chromatograph-mass spectrometer, and measuring the contents. Moreover, the content of components having a molecular weight of 320 in the methylated product of the hydrolyzate of the rosin ester (B) can be calculated from the total amount of components having a molecular weight of 314 to 320 by hydrolyzing the rosin ester, then methylating the hydrolyzate, and performing quantification by a gas chromatograph-mass spectrometer.

Hydrolysis of the rosin ester (B) can be carried out by, for example, dissolving the rosin ester in n-hexanol, adding potassium hydroxide to the solution, and refluxing the solution for 2 hours to allow a hydrolysis reaction. After this hydrolysis, hydrochloric acid is added for neutralization, methylation is performed, and then the solution is subjected to the aforementioned analysis. Methylation can be carried out by, for example, diluting the solution with an on-column methylating agent and introducing the dilution into a gas chromatograph-mass spectrometer (GC/MS). As an on-column methylating agent, for example, a 0.2 mol methanol solution of phenyltrimethylammonium hydroxide (PTHA) is usable.

The color tone of the rosin ester (B) is not particularly limited, and it is preferable that the rosin ester (B) has a color tone of 3 or less on the Gardner color scale specified in JIS K 0071-2 because the color of a hot melt adhesive composition obtained by using such a rosin ester is a pale color. As the Gardner color scale of the component (B) increases beyond 3, the color of the resulting adhesive composition becomes yellowish brown to reddish brown.

The hydroxyl value of the rosin ester (B) is not particularly limited, and a hydroxyl value of about 30 mg KOH/g or less is preferable because compatibility with the component (A) improves even more, and adhesion improves.

The rosin ester (B) can be prepared by, for example, esterifying a rosin (b1) with an alcohol (b2) or a glycidyl group-containing compound (b3) and then hydrogenating the ester. Alternatively, it can be prepared by, for example, hydrogenating a rosin (b1) and then esterifying the hydrogenate with an alcohol (b2) or a glycidyl group-containing compound (b3). Moreover, it can be prepared by, for example, hydrogenating a rosin (b1), further mixing the rosin (b1), and then esterifying the mixture with an alcohol (b2) or a glycidyl group-containing compound (b3).

As the rosin (b1) used for producing the rosin ester (B), various kinds of rosin can be used without particular limitations. For example, natural rosins such as gum rosin, tall oil rosin, and wood rosin; purified rosins obtained by purifying natural rosins; hydrogenated rosins obtained by subjecting natural rosins to a hydrogenation reaction; disproportionated rosins obtained by subjecting natural rosins to a disproportionation reaction; unsaturated carboxylic acid-modified rosins obtained by modifying natural rosins with unsaturated carboxylic acids such as maleic acid, fumaric acid, and acrylic acid; and the like can be suitably used.

Purified rosins can be obtained by performing various known means such as a distillation method, an extraction method, and a recrystallization method on rosins. The distillation method can be usually performed, for example, at a temperature of about 200 to about 300°C under a reduced pressure of about 0.01 to about 3 kPa. In the extraction method, the aforementioned rosin is formed into an aqueous alkaline solution, insoluble unsaponifiable matter is extracted by various organic solvents, and then the aqueous layer is neutralized. In the recrystallization method, a purified rosin is obtained by dissolving the aforementioned rosin in an organic solvent as a good solvent, then distilling off the solvent to form a thick solution, and, further, adding an organic solvent as a poor solvent.

Disproportionated rosins can be obtained using various known means. For example, a disproportionated rosin is obtained by thermally reacting a rosin in the presence a disproportionation catalyst. Examples of disproportionation catalysts include various known catalysts, e.g., metal-supported catalysts such as palladium carbon, rhodium carbon, and platinum carbon; metal powders such as nickel and platinum; iodine and iodides such as iron iodide; and the like. It is usually preferable that the amount of catalyst is about 0.01 to about 5 wt% based on 100 parts by weight of rosin, and more preferably about 0.01 to about 1 wt%. Moreover, the reaction temperature is preferably about 100 to about 300°C and more preferably about 150°C to about 290°C.

Examples of the alcohol (b2) used for producing the component (B) include monohydric alcohols such as methanol, ethanol, isopropyl alcohol, butyl alcohol, n-octyl alcohol, 2-ethylhexyl alcohol, decyl alcohol, and lauryl alcohol; dihydric alcohols such as ethylene glycol, diethylene glycol, triethylene glycol, propylene glycol, neopentyl glycol, and cyclohexanedimethanol; trihydric alcohols such as glycerin, trimethylolethane, and trimethylolpropane; tetrahydric alcohols such as pentaerythritol and diglycerin; hexahydric alcohols such as dipentaerythritol; and the like. Any one of these can be used alone, or two or more can be used as a mixture. As the alcohol (b2), a trihydric alcohol such as glycerin, trimethylolethane, or trimethylolpropane in particular is preferable because a rosin ester having a sharp molecular weight distribution and a suitable softening point is obtained. Moreover, the use of an alcohol having a valency of 4 or greater, such as pentaerythritol, diglycerin, or dipentaerythritol, makes it possible to easily obtain a rosin ester having a softening point of 95°C or higher, resulting in good heat resistance and retentivity, and it is thus preferable to use such an alcohol. Examples of the glycidyl group-containing compound (b3) include glycidylether, glycidol, and the like that form esters by reaction with carboxylic acids, and any one of these can be used alone, or two or more can be used as a mixture.

The esterification reaction can be performed by a known esterification method. Specifically, the esterification reaction is performed at about 150 to about 300°C while removing generated water from the system. Since the presence of air during the esterification reaction may result in generation of a colored esterification product, it is preferable to perform the reaction in an inert gas atmosphere of nitrogen, helium, argon, or the like. When performing the reaction, an esterification catalyst is not necessarily needed, but it is possible to use acid catalysts such as acetic acid and p-toluenesulfonic acid; alkali metal hydroxides such as calcium hydroxide; metal oxides such as calcium oxide and magnesium oxide; and the like to shorten the reaction time.

The hydrogenation reaction can be performed using various known means. For example, the hydrogenation reaction is performed in the presence of a hydrogenation catalyst usually under a hydrogen pressure of about 1 to about 25 MPa, preferably about 5 to about 20 MPa for about 0.5 to about 7 hours, preferably about 1 to about 5 hours. Usable hydrogenation catalysts include various known catalysts, e.g., metal-supported catalysts such as palladium carbon, rhodium carbon, ruthenium carbon, and platinum carbon; metal powders such as nickel and platinum; iodine and iodides such as iron iodide; and the like. Among these, metal catalysts such as palladium, rhodium, ruthenium, and platinum are preferable in terms of excellent hydrogenation efficiency (a high hydrogenation rate and a short hydrogenation time). It is usually preferable that the amount of catalyst is about 0.01 to about 10 parts by weight based on 100 parts by weight of the hydrogenation target, and more preferably about 0.01 to about 5 parts by weight. Moreover, it is usually preferable that the hydrogenation temperature is about 100 to about 300°C and more preferably about 150 to about 290°C. Moreover, the hydrogenation reaction may be performed on a rosin that is in a solvent-dissolved state as necessary. The solvent used is not particularly limited, and it may be a solvent in which raw materials and products easily dissolve. For example, one of, or a combination of two or more of, hydrocarbons such as cyclohexane, n-hexane, methylcyclohexane, n-heptane, and decalin; ethers such as tetrahydrofuran and dioxane; terpenes such as pinene, pinane, and turpentine oil; and the like can be used. The amount of solvent is not particularly limited, and it is usually preferable that the solid content is about 10 wt% or greater of the hydrogenation target, and more preferably in a range of about 10 to about 70 wt%.

As described above, the rosin ester (B) is obtained by esterifying the rosin (b1) with the alcohol (b2) or the glycidyl group-containing compound (b3) and then hydrogenating the ester, or by hydrogenating the rosin (b1) into a hydrogenated rosin and esterifying it with the alcohol (b2) or the glycidyl group-containing compound (b3). Moreover, in order for the amount of dehydroabietic acid and abietic acid in the hydrolyzate and the amount of components having a molecular weight of 320 in the methylated product of the hydrolyzate to be in predetermined ranges, the rosin (b1) may be further added to the hydrogenated rosin obtained by hydrogenating the rosin (b1), and then esterification may be performed with the alcohol (b2) or the glycidyl group-containing compound (b3). Furthermore, yet another rosin ester may be suitably mixed with the resulting hydrogenated rosin ester as necessary. Moreover, in the case of using a disproportionated rosin in which the dehydroabietic acid content is relatively high or a natural rosin in which the abietic acid content is relatively high as the rosin (b1), it is possible to take measures such as using a catalyst having high hydrogenation activity, e.g., a platinum catalyst, increasing the amount of catalyst, or raising the hydrogen pressure. In this way, configuring the dehydroabietic acid content to be 30 wt% or less and the abietic acid content to be 10 wt% or less in the hydrolyzate of the resulting rosin ester (B) and components having a molecular weight of 320 in the methylated product of the hydrolyzate thereof to be equal to or greater than 10 wt% of the total amount of components having a molecular weight of 314 to 320 makes it possible to demonstrate the effects of the present invention. The resulting component (B) is usually a colorless-transparent or brown resin having a softening point of about 130°C or less and an acid value of about 50 mg KOH/g or less.

The amount of the rosin ester (B) used in the adhesive composition of the present invention is not particularly limited, and it is usually preferable that the amount is about 20 to about 200 parts by weight based on 100 parts by weight of the ethylene copolymer (A) in terms of obtaining good adhesion.

A wax can be suitably blended with the hot melt adhesive composition of the present invention as necessary. Usable waxes are not particularly limited, and examples include petroleum waxes such as paraffin wax and microcrystalline wax; synthetic waxes such as polyethylene wax, polypropylene wax, atactic polypropylene wax, ethylene-carbon monoxide copolymer wax, and Fischer-Tropsch wax; and the like. One of these waxes may be used alone, or two or more may be used as a mixture. When the hot melt adhesive of the present invention also contains the aforementioned wax, the content thereof is preferably about 1 to about 80 wt% and more preferably about 5 to about 60 wt% in the adhesive. The wax used in an amount of about 80 wt% or less results in good adhesion.

It is also possible to concomitantly use a polymer other than the ethylene copolymer (A) in the hot melt adhesive composition of the present invention. Polymers that can be concomitantly used are not particularly limited, and examples include polyolefine, polystyrene, polyacrylate, polyvinyl acetate, ethylene-vinyl acetate copolymer (EVA), styrenic block rubber, and the like.

Additives such as antioxidants, stabilizers, anti-aging agents, photostabilizers, lubricants, anti-blocking agents, antistatic agents, anti-fogging agents, coloring materials, fillers, and plasticizers can be added to the hot melt adhesive composition of the present invention as necessity.

### EXAMPLES

The present invention will now be described in more detail below by way of production examples, comparative production examples, examples, and comparative examples. However, the present invention is not limited by these examples.

Various properties of rosin esters (including hydrogenated rosin esters) obtained in production examples and comparative production examples were measured as follows.

### Quantification of content of components having molecular weight of 320 in methylated product of hydrolyzate of rosin ester

A test rosin ester was dissolved in n-hexanol, potassium hydroxide was added to the solution, a reflux reaction was performed for 2 hours for hydrolysis, thereafter the reaction product was neutralized by hydrochloric acid, then the hydrolyzate was diluted to 1 wt% with an on-column methylating agent [a 0.2 mol methanol solution of phenyltrimethylammonium hydroxide (PTHA), manufactured by GL Sciences Inc.], 1 µl of the dilution was charged into a gas chromatograph-mass spectrometer (GC/MS), and measurement was performed. The ratio of the peak area of components having a molecular weight of 320 to the total peak area of components having a molecular weight of 314 to 320 was measured, and this was regarded as the content of components having a molecular weight of 320.

The GC/MS used was as follows.
Gas chromatograph: "Agilent 6890" (trade name, manufactured by Agilent Technologies Inc.)
Mass spectrometer: "Agilent 5973" (trade name, manufactured by Agilent Technologies Inc.)
Column: "Advance-DS" (trade name, manufactured by Shinwa Chemical Industries Ltd.)

### Quantification of dehydroabietic acid and abietic acid contents in hydrolyzate of rosin ester

A rosin ester was hydrolyzed in the same manner as above, the hydrolyzate was diluted to 1 wt% with an on-column methylating agent (a 0.2 mol methanol solution of phenyltrimethylammonium hydroxide (PTHA), manufactured by GL Sciences Inc.), 1 µl of the dilution was charged into a gas chromatograph-mass spectrometer (GC/MS), and measurement was performed. The ratio of peak areas indicating methyl dehydroabietate and methyl abietate was regarded as the dehydroabietic acid and abietic acid content. The gas chromatograph used was the same as the device used for quantifying the content of components having a molecular weight of 320 in the methylated product of the hydrolyzate.

### Hydroxyl value

The hydroxyl value was measured by a potentiometric titration method in accordance with JIS K 0070.

### Acid value

The acid value was measured by a potentiometric titration method in accordance with JIS K 0070.

### Color tone

The color tone was measured by the Gardner color scale in accordance with JIS K 0071-2.

### Softening point

The softening point was measured by a ring and ball method of JIS K 5902.

### Production Example 1 (production of rosin ester)

500 g of hydrogenated rosin manufactured in China (manufactured by Wuzhou Sun Shine Forestry and Chemicals Co., Ltd.) and 63 g of glycerin were charged into a 1 liter flask equipped with a stirrer, a cooling tube, and a nitrogen introduction tube, the temperature was increased to 260°C to carry out a reaction for 8 hours, and 480 g of a hydrogenated rosin ester was obtained. In the obtained rosin ester, the content of components having a molecular weight of 320 was 18 wt% of the total amount of components having a molecular weight of 314 to 320 as measured by gas chromatography mass spectrometry on the methylated product of the hydrolyzate, the dehydroabietic acid content was 8 wt%, and the abietic acid content was 0 wt%. The hydroxyl value was 28 mg KOH/g, the acid value was 4 mg KOH/g, the color tone was 5 on the Gardner color scale, and the softening point was 86°C.

### Production Example 2 (production of rosin ester)

200 g of hydrogenated rosin manufactured in China (manufactured by Wuzhou Sun Shine Forestry and Chemicals Co., Ltd.), 3 g of 5 wt% palladium alumina powder (manufactured by N.E. Chemcat Corporation), and 200 g of cyclohexane were charged into a 1 liter autoclave, oxygen present in the system was removed, hydrogen gas was introduced into the system to increase the pressure to 6 MPa, and the temperature was increased to 200°C. After reaching the temperature, the system was pressurized again, the pressure was maintained at 9 MPa, a hydrogenation reaction was carried out for 4 hours, the catalyst was filtered off, then cyclohexane was removed under reduced pressure, and 189 g of a hydrogenated product was obtained.

Then, 180 g of the obtained hydrogenated product and 21 g of glycerin were charged into a 0.5 liter flask equipped with a stirrer, a cooling tube, and a nitrogen introducing tube, and reacted at 280°C for 10 hours, and 175 g of a hydrogenated rosin ester was obtained.

170 g of the rosin ester obtained above, 1 g of 5 wt% palladium carbon (having a moisture content of 50 wt%), and 170 g of cyclohexane were charged into a 1 liter autoclave, oxygen present in the system was removed, hydrogen gas was introduced into the system to increase the pressure to 6 MPa, and then the temperature was increased to 200°C. After reaching the temperature, the system was pressurized again, the pressure was maintained at 9 MPa, a hydrogenation reaction was carried out for 4 hours, the solvent was filtered off, then cyclohexane was removed under reduced pressure, and 164 g of a rosin ester was obtained. In the obtained rosin ester, the content of components having a molecular weight of 320 was 97 wt% of the total amount of components having a molecular weight of 314 to 320 as measured by gas chromatography mass spectrometry on the methylated product of the hydrolyzate, the dehydroabietic acid content was 3 wt%, and the abietic acid content was 0 wt%. The hydroxyl value was 12 mg KOH/g, the acid value was 7 mg KOH/g, the color tone was less than 1 on the Gardner color scale, and the softening point was 91°C.

### Production Example 3 (production of rosin ester)

500 g of hydrogenated rosin manufactured in China (manufactured by Wuzhou Sun Shine Forestry and Chemicals Co., Ltd.) and 70 g of glycerin were charged into a 1 liter flask equipped with a stirrer, a cooling tube, and a nitrogen introduction tube, the temperature was increased to 260°C to carry out a reaction for 7 hours, and 480 g of a hydrogenated rosin ester was obtained. In the obtained rosin ester, the content of components having a molecular weight of 320 was 17 wt% of the total amount of components having a molecular weight of 314 to 320 as measured by gas chromatography mass spectrometry on the methylated product of the hydrolyzate, the dehydroabietic acid content was 7 wt%, and the abietic acid content was 1 wt%. The hydroxyl value was 36 mg KOH/g, the acid value was 4 mg KOH/g, the color tone was 8 on the Gardner color scale, and the softening point was 82°C.

### Production Example 4 (production of rosin ester)

500 g of hydrogenated rosin manufactured in China (manufactured by Wuzhou Sun Shine Forestry and Chemicals Co., Ltd.) and 81 g of trimethylol propane were charged into a 1 liter flask equipped with a stirrer, a cooling tube, and a nitrogen introduction tube, the temperature was increased to 260°C to carry out a reaction for 9 hours, and 470 g of a hydrogenated rosin ester was obtained. In the obtained rosin ester, the content of components having a molecular weight of 320 was 16 wt% of the total amount of components having a molecular weight of 314 to 320 as measured by gas chromatography mass spectrometry on the methylated product of the hydrolyzate, the dehydroabietic acid content was 9 wt%, and the abietic acid content was 1 wt%. The hydroxyl value was 18 mg KOH/g, the acid value was 5 mg KOH/g, the color tone was 8 on the Gardner color scale, and the softening point was 87°C.

### Production Example 5 (production of rosin ester)

500 g of hydrogenated rosin manufactured in China (manufactured by Wuzhou Sun Shine Forestry and Chemicals Co., Ltd.) and 75 g of pentaerythritol were charged into a 1 liter flask equipped with a stirrer, a cooling tube, and a nitrogen introduction tube, the temperature was increased to 270°C to carry out a reaction for 9 hours, and 470 g of a hydrogenated rosin ester was obtained. In the obtained rosin ester, the content of components having a molecular weight of 320 was 18 wt% of the total amount of components having a molecular weight of 314 to 320 as measured by gas chromatography mass spectrometry on the methylated product of the hydrolyzate, the dehydroabietic acid content was 8 wt%, and the abietic acid content was 1 wt%. The hydroxyl value was 45 mg KOH/g, the acid value was 16 mg KOH/g, the color tone was 9 on the Gardner color scale, and the softening point was 96°C.

### Production Example 6 (production of rosin ester)

500 g of hydrogenated rosin manufactured in China (manufactured by Wuzhou Sun Shine Forestry and Chemicals Co., Ltd.) and 500 g of gum rosin manufactured in China were charged into a 2 liter flask equipped with a nitrogen introduction tube and distilled under a reduced pressure of 400 Pa. 500 g of the fraction distilled at 195 to 250°C, 49 g of glycerin, 2 g of 4,4'-thiobis(6-tert-butyl-m-cresol) (antioxidant, trade name "SUMILIZER WX-R", manufactured by Sumitomo Chemical Co., Ltd), and 2 g of 4,4'-butylidenebis(3-methyl-6-tert-butylphenol)bis(ditridecyl phosphite) (antioxidant, trade name "Adekastab 260") were charged into a 1 liter flask equipped with a stirrer, a cooling tube, and a nitrogen introduction tube, the temperature was increased to 270°C, a reaction was carried out for 12 hours, and 470 g of a hydrogenated rosin ester was obtained. In the obtained rosin ester, the content of components having a molecular weight of 320 was 11 wt% of the total amount of components having a molecular weight of 314 to 320 as measured by gas chromatography mass spectrometry on the methylated product of the hydrolyzate, the dehydroabietic acid content was 27 wt%, and the abietic acid content was 3 wt%. The hydroxyl value was 7 mg KOH/g, the acid value was 20 mg KOH/g, the color tone was 2 on the Gardner color scale, and the softening point was 91°C.

### Production Example 7 (production of rosin ester)

500 g of hydrogenated rosin manufactured in China (manufactured by Hunan Sonbon Forestry Science and Technology Co., Ltd.) and 60 g of pentaerythritol were charged into a 1 liter flask equipped with a stirrer, a cooling tube, and a nitrogen introduction tube, the temperature was increased to 270°C, a reaction was carried out for 11 hours, and 470 g of a hydrogenated rosin ester was obtained. In the obtained rosin ester, the content of components having a molecular weight of 320 was 38 wt% of the total amount of components having a molecular weight of 314 to 320 as measured by gas chromatography mass spectrometry on the methylated product of the hydrolyzate, the dehydroabietic acid content was 10 wt%, and the abietic acid content was 1 wt%. The hydroxyl value was 26 mg KOH/g, the acid value was 30 mg KOH/g, the color tone was 8 on the Gardner color scale, and the softening point was 104°C.

### Production Example 8 (production of rosin ester)

1 kg of hydrogenated rosin manufactured in China (manufactured by Wuzhou Sun Shine Forestry and Chemicals Co., Ltd.) was introduced into a 2 liter flask equipped with a nitrogen introduction tube and distilled under a reduced pressure of 400 Pa. 500 g of the fraction distilled at 195 to 250°C, 49 g of glycerin, 2 g of 4,4'-thiobis(6-tert-butyl-m-cresol) (antioxidant, trade name "SUMILIZER WX-R", manufactured by Sumitomo Chemical Co., Ltd), and 2 g of 4,4'-butylidenebis(3-methyl-6-tert-butylphenol)bis(ditridecyl phosphite) (antioxidant, trade name "Adekastab 260") were charged into a 1 liter flask equipped with a stirrer, a cooling tube, and a nitrogen introduction tube, the temperature was increased to 270°C, a reaction was carried out for 11 hours, and 470 g of a hydrogenated rosin ester was obtained. In the obtained rosin ester, the content of components having a molecular weight of 320 was 14 wt% of the total amount of components having a molecular weight of 314 to 320 as measured by gas chromatography mass spectrometry on the methylated product of the hydrolyzate, the dehydroabietic acid content was 10 wt%, and the abietic acid content was 0 wt%. The hydroxyl value was 9 mg KOH/g, the acid value was 15 mg KOH/g, the color tone was 2 on the Gardner color scale, and the softening point was 93°C.

### Production Example 9 (production of rosin ester)

1 kg of hydrogenated rosin manufactured in China (manufactured by Wuzhou Sun Shine Forestry and Chemicals Co., Ltd.) was introduced into a 2 liter flask equipped with a nitrogen introduction tube and distilled under a reduced pressure of 400 Pa. 500 g of the fraction distilled at 195 to 250°C, 60 g of pentaerythritol, 2 g of 4,4'-thiobis(6-tert-butyl-m-cresol) (antioxidant, trade name "SUMILIZER WX-R", manufactured by Sumitomo Chemical Co., Ltd), and 2 g of 4,4'-butylidenebis(3-methyl-6-tert-butylphenol)bis(ditridecyl phosphite)(antioxidant, trade name "Adekastab 260") were charged into a 1 liter flask equipped with a stirrer, a cooling tube, and a nitrogen introduction tube, the temperature was increased to 270°C, a reaction was carried out for 12 hours, and 470 g of a hydrogenated rosin ester was obtained. In the obtained rosin ester, the content of components having a molecular weight of 320 was 14 wt% of the total amount of components having a molecular weight of 314 to 320 as measured by gas chromatography mass spectrometry on the methylated product of the hydrolyzate, the dehydroabietic acid content was 11 wt%, and the abietic acid content was 0 wt%. The hydroxyl value was 24 mg KOH/g, the acid value was 28 mg KOH/g, the color tone was 3 on the Gardner color scale, and the softening point was 109°C.

### Comparative Production Example 1 (production of rosin ester)

500 g of gum rosin manufactured in China and 63 g of glycerin were charged into a 1 liter flask equipped with a stirrer, a cooling tube, and a nitrogen introduction tube, the temperature was increased to 270°C to carry out a reaction for 8 hours, and 470 g of a rosin ester was obtained. In the obtained rosin ester, the content of components having a molecular weight of 320 was 4 wt% of the total amount of components having a molecular weight of 314 to 320 as measured by gas chromatography mass spectrometry on the methylated product of the hydrolyzate, the dehydroabietic acid content was 30 wt%, and the abietic acid content was 21 wt%. The hydroxyl value was 24 mg KOH/g, the acid value was 4 mg KOH/g, the color tone was 9 on the Gardner color scale, and the softening point was 87°C.

### Comparative Production Example 2 (production of rosin ester)

500 g of disproportionated rosin manufactured in China and 63 g of glycerin were charged into a 1 liter flask equipped with a stirrer, a cooling tube, and a nitrogen introduction tube, the temperature was increased to 260°C to carry out a reaction for 8 hours, and 480 g of a rosin ester was obtained. 170 g of the rosin ester obtained above, 1 g of 5 wt% palladium carbon (having a moisture content of 50 wt%), and 170 g of cyclohexane were charged into a 1 liter autoclave, oxygen present in the system was removed, hydrogen gas was introduced into the system to increase the pressure to 6 MPa, and then the temperature was increased to 200°C. After reaching the temperature, the system was pressurized again, the pressure was maintained at 9

MPa, a hydrogenation reaction was carried out for 4 hours, the solvent was filtered off, then cyclohexane was removed under reduced pressure, and 160 g of a hydrogenated rosin ester was obtained. In the obtained rosin ester, the content of components having a molecular weight of 320 was 18 wt% of the total amount of components having a molecular weight of 314 to 320 as measured by gas chromatography mass spectrometry on the methylated product of the hydrolyzate, the dehydroabietic acid content was 60 wt%, and the abietic acid content was 0 wt%. The hydroxyl value was 9 mg KOH/g, the acid value was 6 mg KOH/g, the color tone was 1 on the Gardner color scale, and the softening point was 97°C.

### Comparative Production Example 3 (production of rosin ester)

500 g of disproportionated rosin manufactured in China and 58 g of glycerin were charged into a 1 liter flask equipped with a stirrer, a cooling tube, and a nitrogen introduction tube, the temperature was increased to 270°C to carry out a reaction for 8 hours, and 467 g of a rosin ester was obtained. In the obtained rosin ester, the content of components having a molecular weight of 320 was 7 wt% of the total amount of components having a molecular weight of 314 to 320 as measured by gas chromatography mass spectrometry on the methylated product of the hydrolyzate, the dehydroabietic acid content was 59 wt%, and the abietic acid content was 0 wt%. The hydroxyl value was 18 mg KOH/g, the acid value was 6 mg KOH/g, the color tone was 3 on the Gardner color scale, and the softening point was 96°C.

### Comparative Production Example 4 (production of rosin ester)

1 kg of gum rosin manufactured in China was introduced into a 2 liter flask equipped with a nitrogen introduction tube and distilled under a reduced pressure of 400 Pa. 500 g of the fraction distilled at 195 to 250°C, 65 g of pentaerythritol, 2 g of 4,4'-thiobis(6-tert-butyl-m-cresol) (antioxidant, trade name "SUMILIZER WX-R", manufactured by Sumitomo Chemical Co., Ltd), and 2 g of 4,4'-butylidenebis(3-methyl-6-tert-butylphenol)bis(ditridecyl phosphite) (antioxidant, trade name "Adekastab 260") were charged into a 1 liter flask equipped with a stirrer, a cooling tube, and a nitrogen introduction tube, the temperature was increased to 270°C, a reaction was carried out for 11 hours, and 470 g of a rosin ester was obtained. In the obtained rosin ester, the content of components having a molecular weight of 320 was 0 wt% of the total amount of components having a molecular weight of 314 to 320 as measured by gas chromatography mass spectrometry on the methylated product of the hydrolyzate, the dehydroabietic acid content was 52 wt%, and the abietic acid content was 4 wt%. The hydroxyl value was 32 mg KOH/g, the acid value was 27 mg KOH/g, the color tone was 2 on the Gardner color scale, and the softening point was 105°C.

### Comparative Production Example 5 (production of rosin ester)

330 g of hydrogenated rosin manufactured in China (manufactured by Wuzhou Sun Shine Forestry and Chemicals Co., Ltd.) and 660 g of gum rosin manufactured in China were charged into a 2 liter flask equipped with a nitrogen introduction tube and distilled under a reduced pressure of 400 Pa. 500 g of the fraction distilled at 195 to 250°C, 57 g of pentaerythritol, 2 g of 4,4'-thiobis(6-tert-butyl-m-cresol) (antioxidant, trade name "SUMILIZER WX-R", manufactured by Sumitomo Chemical Co., Ltd), and 2 g of 4,4'-butylidenebis(3-methyl-6-tert-butylphenol)bis(ditridecyl phosphite) (antioxidant, trade name "Adekastab 260") were charged into a 1 liter flask equipped with a stirrer, a cooling tube, and a nitrogen introduction tube, the temperature was increased to 270°C, a reaction was carried out for 12 hours, and 470 g of a hydrogenated rosin ester was obtained. In the obtained rosin ester, the content of components having a molecular weight of 320 was 5 wt% of the total amount of components having a molecular weight of 314 to 320 as measured by gas chromatography mass spectrometry on the methylated product of the hydrolyzate, the dehydroabietic acid content was 37 wt%, and the abietic acid content was 3 wt%. The hydroxyl value was 27 mg KOH/g, the acid value was 8 mg KOH/g, the color tone was 3 on the Gardner color scale, and the softening point was 102°C.

### Example 1

40 parts by weight of the hydrogenated rosin ester obtained in Production Example 1, 40 parts by weight of "Affinity GA 1900" (trade name, an ethylene polymer polymerized in the presence of a metallocene catalyst, manufactured by The Dow Chemical Company), and 20 parts by weight of microcrystalline wax were melt-kneaded, and a hot melt adhesive composition was obtained. This adhesive composition was applied to an adherend by a #20 bar coater at 180°C and cooled to room temperature, and the coated adherend was cut to a width of 25 mm. The adherend was pressure-bonded by a heat sealer under conditions of 150°C, 0.2 MPa, and 1 sec and left to stand at 23°C for 24 hours, and a bonded article was obtained. Then, the adhesion thereof was measured for evaluation. As adherends, aluminum foil and untreated PET film ("Lumirror 75T60" (trade name, manufactured by Toray Industries Inc.) were used.

### Examples 2 to 9 and Comparative Examples 1 to 6

Evaluations were carried out in the same manner as in Example 1 except that the formulation of the hot melt adhesive composition was changed as shown in Table 1.

### Adhesion

In examples and comparative examples, adhesion was measured in the following manner. That is, the obtained bonded article was subjected to a 180° peeling test using a Tensilon tensile tester under conditions of 23°C and a peel rate of 300 mm/min to measure adhesion (N/25 mm).

Table 1 shows the rosin esters used in the examples and the comparative examples as well as measurement results of adhesion to aluminum foil and PET film.

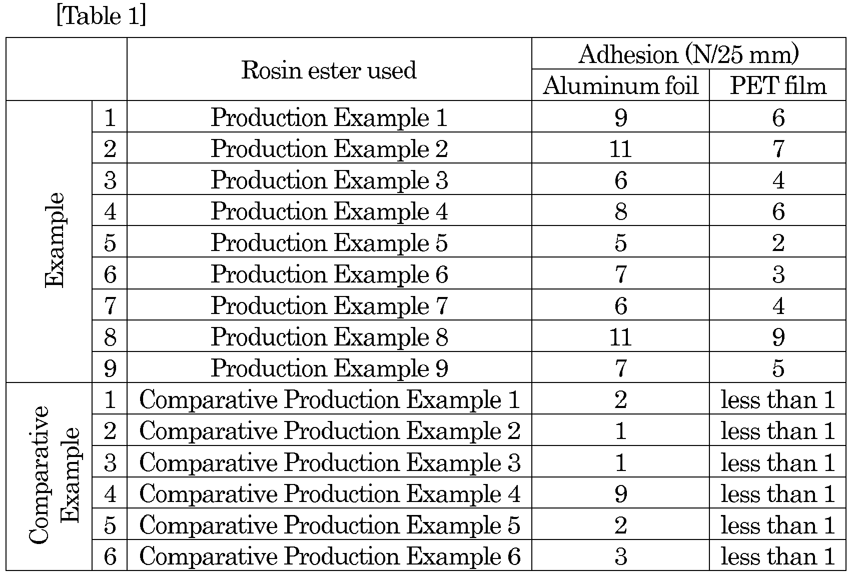

### INDUSTRIAL APPLICABILITY

The ethylene copolymer-based hot melt adhesive composition of the present invention has excellent adhesion to adherends having a broad range of polarity and therefore can be suitably used when adhering a variety of weakly polar or highly polar adherends.

## Claims

1. A hot melt adhesive composition comprising:
(A) an ethylene copolymer obtained by copolymerizing ethylene and α-olefin using a single-site catalyst, and
(B) a rosin ester, in a hydrolyzate of which a dehydroabietic acid content is 30 wt% or less and an abietic acid content is 10 wt% or less, and in a methylated product of the hydrolyzate of which a content of components having a molecular weight of 320 is equal to or greater than 10 wt% of a total amount of components having a molecular weight of 314 to 320.

2. The hot melt adhesive composition according to claim 1, wherein the ethylene copolymer (A) has a melt flow rate of 2500 g/10 min (190°C, 21.2 N).

3. The hot melt adhesive composition according to claim 1, wherein the ethylene copolymer (A) has a density in a range of 0.86 to 0.92 g/cm³.

4. The hot melt adhesive composition according to claim 1, wherein the rosin ester (B) is a rosin ester, in a hydrolyzate of which a dehydroabietic acid content is 20 wt% or less and an abietic acid content is 10 wt% or less, and in a methylated product of the hydrolyzate of which a content of components having a molecular weight of 320 is equal to or greater than 15 wt% of a total amount of components having a molecular weight of 314 to 320 in the methylated product.

5. The hot melt adhesive composition according to claim 1, wherein the rosin ester (B) has a color tone of 3 or less on Gardner color scale specified in JIS K 0071-2.

6. The hot melt adhesive composition according to claim 1, wherein the rosin ester (B) has a hydroxyl value of 30 mg KOH/g or less.

7. The hot melt adhesive composition according to claim 1, wherein the rosin ester (B) is obtained by esterifying a rosin (b1) with an alcohol (b2) or a glycidyl group-containing compound (b3) and then hydrogenating an ester.

8. The hot melt adhesive composition according to claim 7, wherein the alcohol (b2) is a trihydric alcohol or an alcohol having a valency of 4 or greater.

9. The hot melt adhesive composition according to claim 1, wherein the rosin ester (B) is obtained by hydrogenating a rosin (b1) and then esterifying a hydrogenate with an alcohol (b2) or a glycidyl group-containing compound (b3).

10. The hot melt adhesive composition according to claim 9, wherein the alcohol (b2) is a trihydric alcohol or an alcohol having a valency of 4 or greater.

11. The hot melt adhesive composition according to claim 1, wherein the rosin ester (B) is obtained by hydrogenating a rosin (b1), further mixing the rosin (b1), and then esterifying a mixture with an alcohol (b2) or a glycidyl group-containing compound (b3).

12. The hot melt adhesive composition according to claim 10, wherein the alcohol (b2) is a trihydric alcohol or an alcohol having a valency of 4 or greater.

13. The hot melt adhesive composition according to claim 1, having a content of the rosin ester (B) of 20 to 200 parts by weight based on 100 parts by weight of the ethylene copolymer (A).
